# EUROPEAN PATENT APPLICATION

(11) **EP 2 842 911 A1**
(43) Date of publication of application: **04.03.2015**
(21) Application number: 14181363.4
(22) Date of filing: 19.08.2014
(51) Int. Cl.: C01B 31/04, B82Y 30/00

(54) **Coating, coating method, and coated article**

(30) Priority: 29.08.2013 US 201314013369
(71) Applicant: General Electric Company, Schenectady, New York 12345 (US)
(72) Inventor: Kalaga, Murali Krishna, 560066 Bangalore, Karnataka (IN); Bhattacharyya, Arjun, 560066 Banagalore, Karnataka (IN); Devi, Rebika Mayanglambam, 560066 Banagalore, Karnataka (IN); Schaeffer, Jon Conrad, Greenville, SC South Carolina 29615 (US); Parakala, Padmaja, 50038 Hyderabad. Ahdhra Pradesh (IN); Pabla, Surinder S., Greenville, SC South Carolina 29615 (US)
(74) Representative: Szary, Anne Catherine

(57) **Abstract**

A coating method, coated article and coating are provided. The coated article includes a low temperature component, and a graphene coating formed from a graphene derivative applied over the low temperature component. The coating method includes providing a graphene derivative, providing a low temperature component, applying the graphene derivative over the low temperature component, and forming a graphene coating. The graphene coating reduces corrosion and fouling of the low temperature component. The coating includes a graphene derivative, and modified functional groups on the graphene derivative. The modified functional groups increase adherence of the coating on application to a low temperature component.

## Description

### FIELD OF THE INVENTION

The present invention is directed to a coating, a coating method, and a coated article. More specifically, the present invention is directed to a graphene coating, a method of forming a graphene coating on a low temperature component, and a graphene coated article.

### BACKGROUND OF THE INVENTION

Gas turbine components, particularly gas turbine compressor blades, are exposed to various particles, fluids, temperatures, pressures and fluid velocities which can cause fouling and/or corrosion of the component. During operation, intake air in a gas turbine carries moisture and various particulates which contact the compressor blades. Some of the particulates aggregate on the compressor blades causing a build up, or fouling of the compressor blades.

The fouling of the compressor blades can cause under-deposit corrosion, which is corrosion of the compressor blades underneath the fouling. Additionally, particulates in the intake air may cause foreign object damage (FOD) to the compressor blades and may cause corrosion. Water wash cycles are often performed to remove the particulates that have built up on the compressor blades. However, the water wash cycles expose the compressor blades to increased amounts of moisture, causing corrosion of the compressor blades as well as any portions damaged by FOD. Furthermore, the water wash cycles may utilize chemicals to remove complex particulate build-ups. The chemicals may increase corrosion of the compressor blades, increase maintenance cost, and may be difficult to match with the complex particulate build-ups.

The fouling, corrosion and erosion from airflow over the compressor blades causes decreased efficiency of the gas turbine. A coated compressor blade that does not suffer from one or more of the above drawbacks would be desirable in the art.

### BRIEF DESCRIPTION OF THE INVENTION

In an exemplary embodiment, a coated article includes a low temperature component, and a graphene coating formed from a graphene derivative applied over the low temperature component.

In another exemplary embodiment, a coating method includes providing a graphene derivative, providing a low temperature component, applying the graphene derivative over the low temperature component, and forming a graphene coating. The graphene coating reduces corrosion and fouling of the low temperature component.

In another exemplary embodiment, a coating includes a graphene derivative, and modified functional groups on the graphene derivative. The modified functional groups increase adherence of the coating on application to a low temperature component.

Other features and advantages of the present invention will be apparent from the following more detailed description of the preferred embodiment, taken in conjunction with the accompanying drawings which illustrate, by way of example, the principles of the invention.

### BRIEF DESCRIPTION OF THE DRAWINGS

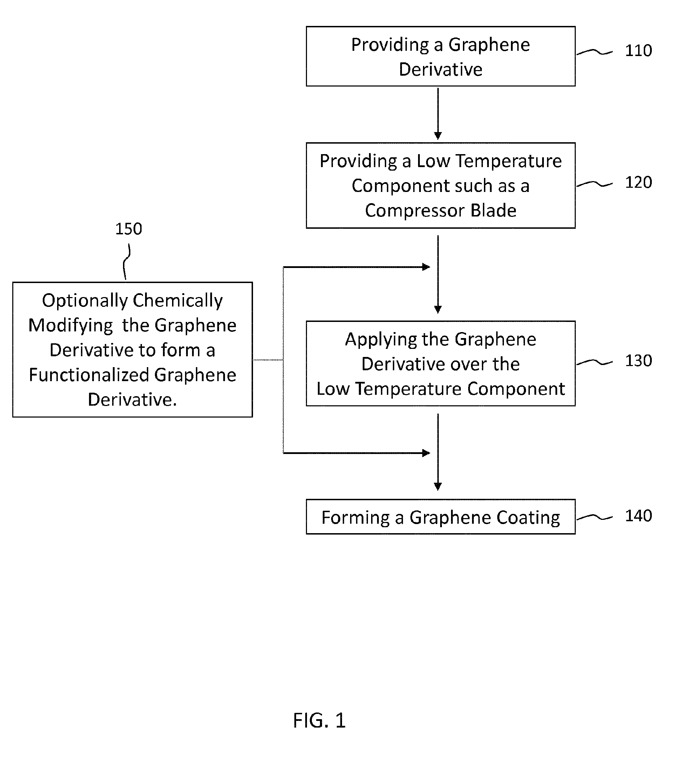

FIG. 1 is a process view of a method of a coating method according to an embodiment of the disclosure.

Wherever possible, the same reference numbers will be used throughout the drawings to represent the same parts.

### DETAILED DESCRIPTION OF THE INVENTION

Provided are a coating method, a coated article, and a coating. Embodiments of the present disclosure, in comparison to methods and articles not using one or more of the features disclosed herein, decrease component corrosion, decrease component fouling, decrease amounts of chromium based metal on the article, decrease amounts of chemical additives required for maintenance, decrease maintenance costs, increase efficiency, or a combination thereof.

Referring to FIG. 1, in one embodiment, a coating method includes providing a graphene derivative (step 110), providing a low temperature component (step 120), applying (step 130) the graphene derivative over the low temperature component, and forming a graphene coating (step 140). In another embodiment, the coating method includes chemically modifying (step 150) the graphene derivative to form a functionalized graphene derivative. The graphene derivative includes, but is not limited to, a graphitic oxide, a graphene oxide, a graphene, a functionalized graphitic oxide, a functionalized graphene oxide, a functionalized graphene, or a combination thereof. In another embodiment, the graphene coating formed over the low temperature component increases a lifespan and/or operational efficiency of the low temperature component. In a further embodiment, the graphene coating reduces corrosion and fouling caused by moisture and impurities such as fine particles of salts and silica. In one embodiment, the graphene coating has sufficient adherence to remain attached to the surface of the rotating component, which experiences very high rotational forces.

The low temperature component includes any suitable component such as, but not limited to, a rotatable component, a compressor blade, piping, heat transfer equipment (e.g. heat exchanges, etc.), a flash drum, an evaporator, a crystallizer, a reactor, a distillation tower, a fluid storage device for fluids up to 600° C, a fluid transport device for fluids up to 600° C, or a combination thereof. In one embodiment, the low temperature component may be a new-make article, or a refurbished part. The refurbished or serviced part includes, but is not limited to, parts undergoing repair operations, improvements, or a combination thereof. Low temperature, as used herein, refers to temperatures of between ambient temperature and about 600° C, preferably between ambient temperature and about 500° C, more preferably between ambient temperature and about 400° C, or any combination, sub-combination, range, or sub-range thereof. Ambient temperature includes, but is not limited to room temperature. As used herein, "room temperature" refers to between about 20° C and about 25° C. In one embodiment, a graphite is oxidized with any suitable oxidizing agent to form the graphite oxide. Suitable oxidizing agents include, but are not limited to, H₂SO₄, KMnO₄, H₂O₂, or a combination thereof. During the oxidation of the graphite, various functional groups are formed on the graphite including, but not limited to, epoxy bridges, hydroxyl groups, pair wise carboxyl groups, or a combination thereof. The functional groups increase a solubility of the graphite oxide such that when added to a liquid, preferably water, the graphite oxide forms a dispersion. In one embodiment, the solid content in the graphite oxide dispersion ranges from about 0.5 mg/mL to about 15 mg/mL. Other suitable liquids include, but are not limited to, mixtures of water and alcohol, organic liquids such as tetrahydrofuran (THF), or a combination thereof. In one embodiment, one or more surfactants are added to the organic liquids to achieve sufficient dispersion of the graphite oxide. The one or more surfactants include, but are not limited to, Sodium Dodecyl Sulphate (SDS), Sodium Dodecyl Benzene Sulfonate (SDBS), Ethylene oxide-Propylene oxide (EO-PO) co-polymer surfactant, silicone-based surfactant, fluoro-surfactants such as per-fluoro octane sulfonic acid and perflouoro octanoic acid, cetyl tri-methyl ammonium bromide (CTAB), and Triton-X100.

In another embodiment, after oxidation, the graphite oxide is sonicated to form the graphene oxide. The sonication includes exfoliating the graphite oxide in the liquid, for example, by ultrasonication. In yet another embodiment, the graphene oxide is then reduced by any suitable reduction agent to form graphene. Suitable reducing agents include, but are not limited to, KOH, N₂H₄, or a combination thereof. In one embodiment, the graphene is a one-atom-thick planar sheet of sp²-bonded carbon atoms that are densely packed in a honeycomb crystal lattice. In another embodiment, the graphene has a density of approximately 1.7 g/cm³.

In one embodiment, the graphene derivative is applied (step 130) at an operational site of the low temperature component. In an alternate embodiment, the graphene derivative is applied (step 130) at a service facility or other remote location. In another embodiment, the graphene derivative is applied (step 130) over any suitable surface of the low temperature component by any suitable application method. A suitable surface of the low temperature component includes, but is not limited to, a substrate, a base coat over the substrate, a plurality of coatings over the substrate, or a combination thereof. Suitable application methods include, but are not limited to, chemical vapor deposition (CVD), screen printing, electrophoresis, thermal spray coating, low temperature application processes, or a combination thereof. Low temperature application processes include, but are not limited to, spray coating, painting, dipping, or a combination thereof.

The graphene derivative is applied over the low temperature component to form the graphene coating (step 140) having a desired thickness. For example, in one embodiment, the graphene coating may include thicknesses from an atomic layer up to 76500 nanometers (3 mils). Preferably, the graphene coating includes thicknesses of from 2 to 20 nanometers. Most preferably, the graphene coating is an ultrathin coating including thicknesses in the range of 0.1 to 2 nanometers. The decreased thickness of the graphene coating decreases a weight of a coated low temperature component as compared to a component with other traditional coatings. The decreased weight of the coated low temperature component increases efficiency of a system having the coated low temperature component. For example, in one embodiment, the graphene coating formed (step 140) on the compressor blade increases efficiency of a turbine system and decreases operational cost. In another embodiment, the decreased thickness of the graphene coating increases cooling rates of the low temperature component as compared to the component with other traditional coating.

In one embodiment, edge portions of the planar sheet of graphene include hydroxyl groups, epoxy groups, and carboxyl groups suitable for the chemical modification (step 150). The chemical modification (step 150) includes the addition of functional groups that change at least one property of the material undergoing the chemical modification (step 150). In another embodiment, the chemical modification (step 150) of the graphite oxide, the graphene oxide, or the graphene forms the functionalized graphitic oxide, the functionalized graphene oxide, or the functionalized graphene, respectively. The functional groups include, but are not limited to, acids, amines, siloxane, sulfur, phosphorous, aliphatic amines, hexamine, dodecylamine, hexadecylamine, octadecylamine, organic isocyanates, hydrocarbons, fluorinated groups, or a combination thereof.

The addition of the sulfur, phosphorous, acids and/or amines increases adhesion of the graphene derivative onto a metal substrate, increasing a capability of the coated metal substrate to withstand corrosion. For example, the graphene derivative including amines is applied (step 130) over the compressor blade having a metal composition to reduce or eliminate the corrosion of the compressor blade. The addition of a C8-C20 hydrocarbon group, a fluorinated group, a siloxane group, or other long chain functional groups increases a functionalization capability, a hydrophobicity and/or oleophobicity of the graphene derivative to reduce or eliminate the corrosion and/or fouling of the low temperature component. For example, in one embodiment, the graphene derivative including siloxane is applied (step 130) over the compressor blade to provide super-hydrophobicity and increased functionalization capability. In another example, the graphene derivative including both amines and siloxane is applied (step 130) over the metal substrate to reduce or eliminate corrosion and provide increased hydrophobicity and oleophobicity.

In one embodiment, a composite coating is formed (step 140) from the dispersed graphene oxide and graphene. For example, the graphene oxide and the graphene are combined in a polymeric solution such as, but not limited to, a resin, a siloxane, or a combination thereof. The composite coating is deposited over the low temperature component, providing an ultrathin coating, decreased fouling of the low temperature component, decreased corrosion of the low temperature component, decreased drag surface finish, increased efficiency, or a combination thereof.

An increased hydrophobicity of graphene contributes to the decreased fouling of the low temperature component. The increased hydrophobicity decreases adhesion of water and harmful particles that may be in the water, as well as other hydrophillic particles to the graphene. The decreased adhesion decreases the aggregation of particles on the graphene, thus decreasing the fouling, and any degradation associated with the fouling. In one embodiment, the graphene coating formed from the graphene derivative, and/or the composite coating include any suitable anti-fouling and low drag surface finish to further increase efficiency. Suitable anti-fouling and low drag surface finishes include, but are not limited to graphene coatings having a roughness average of between about 5 microinches and about 20 microinches. The anti-fouling and low drag surface finish further increases efficiency of the turbine system, and decreases erosion from airflow over the low temperature component. Furthermore, the decreased fouling of the graphene decreases or eliminates water wash cycles designed to remove particles aggregated on the low temperature component. The decreased water wash cycles decreases exposure of the low temperature component to moisture and/or chemical additives, thus decreasing corrosion of the low temperature component.

While the invention has been described with reference to a preferred embodiment, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims.

Various aspects and embodiments of the present invention are defined by the following numbered clauses:
1. A coated article, comprising:
   a low temperature component; and
   a graphene coating formed from a graphene derivative applied over the low temperature component;
   wherein low temperature comprises temperatures of up to about 600° C.
2. The coated article of clause 1, wherein the low temperature component is a rotatable component.
3. The coated article of clause 1 or clause 2, wherein the low temperature component is a gas turbine compressor blade.
4. The coated article of any preceding clause, wherein the graphene derivative is a chemically modified graphene derivative.
5. The coated article of any preceding clause, wherein the graphene coating has a thickness of between about 0.1 nanometers and about 2 nanometers.
6. The coated article of any preceding clause, wherein the graphene coating includes a low drag surface finish.
7. The coated article of any preceding clause, wherein the graphene coating increases at least one property of the low temperature component, the property selected from the group consisting of hydrophobicity and oleophobicity.
8. The coated article of any preceding clause, wherein the graphene coating decreases degradation of the low temperature component.
9. A coating method, comprising:
   providing a graphene derivative;
   providing a low temperature component;
   applying the graphene derivative over the low temperature component; and
   forming a graphene coating;
   wherein low temperature comprises temperatures of up to about 600° C; and
   wherein the graphene coating reduces corrosion and fouling of the low temperature component and is further characterized by resistance to rotational forces.
10. The coating method of clause 9, wherein the graphene derivative is selected from the group consisting of graphite oxide, graphene oxide, graphene, functionalized graphene, functionalized graphene oxide, and functionalized graphitic oxide.
11. The coating method of clause 9 or clause 10, comprising modifying the graphene derivative to form a functionalized graphene derivative.
12. The coating method of clause 11, wherein the modifying of the graphene derivative to form a functionalized graphene derivative is performed either before or after the applying of the graphene derivative over the low temperature component.
13. The coating method of clause 11 or clause 12, further comprising modifying the graphene by adding a functional group selected from the group consisting of sulfur, amines, and acids.
14. The coating method of any one of clauses 11 to 13, wherein modifying the graphene increases a corrosion resistance and fouling resistance of the graphene.
15. The coating method of any one of clauses 11 to 14, wherein modifying the graphene increases adherence of the graphene to the low temperature component.
16. The coating method of any one of clauses 11 to 15, further comprising modifying the graphene by adding a functional group selected from the group consisting of C8-C20 hydrocarbons, fluorinated groups, and siloxane groups.
17. The coating method of any one of clauses 11 to 16, wherein modifying the graphene increases a hydrophobicity and oleophobicity of the graphene.
18. The coating method of any one of clauses 11 to 17, further comprising increasing an anti-fouling property of the graphene by increasing of the hydrophobicity and oleophobicity of the graphene.
19. The coating method of any one of clauses 11 to 18, further comprising applying the graphene derivative with a method selected from the group consisting of chemical vapor deposition, screen printing, electrophoresis, thermal spray coating, spraying, painting, and dipping.
20. A coating, comprising:
   a graphene derivative; and
   modified functional groups on the graphene derivative;
   wherein the modified functional groups increase adherence of the coating on application to a low temperature component while resisting rotational forces; and
   wherein low temperature comprises temperatures of up to about 600° C.

## Claims

1. A coated article, comprising:
a low temperature component; and
a graphene coating formed from a graphene derivative applied over the low temperature component;
wherein low temperature comprises temperatures of up to about 600° C.

2. The coated article of claim 1, wherein the low temperature component is a rotatable component.

3. The coated article of claim 1 or claim 2, wherein the low temperature component is a gas turbine compressor blade.

4. The coated article of any preceding claim, wherein the graphene derivative is a chemically modified graphene derivative.

5. The coated article of any preceding claim, wherein the graphene coating has a thickness of between about 0.1 nanometers and about 2 nanometers.

6. The coated article of any preceding claim, wherein the graphene coating includes a low drag surface finish.

7. The coated article of any preceding claim, wherein the graphene coating increases at least one property of the low temperature component, the property selected from the group consisting of hydrophobicity and oleophobicity.

8. The coated article of any preceding claim, wherein the graphene coating decreases degradation of the low temperature component.

9. A coating method, comprising:
providing a graphene derivative;
providing a low temperature component;
applying the graphene derivative over the low temperature component; and
forming a graphene coating;
wherein low temperature comprises temperatures of up to about 600° C; and
wherein the graphene coating reduces corrosion and fouling of the low temperature component and is further **characterized by** resistance to rotational forces.

10. The coating method of claim 9, wherein the graphene derivative is selected from the group consisting of graphite oxide, graphene oxide, graphene, functionalized graphene, functionalized graphene oxide, and functionalized graphitic oxide.

11. The coating method of claim 9 or claim 10, comprising modifying the graphene derivative to form a functionalized graphene derivative.

12. The coating method of claim 11, wherein the modifying of the graphene derivative to form a functionalized graphene derivative is performed either before or after the applying of the graphene derivative over the low temperature component.

13. The coating method of claim 11 or claim 12, further comprising modifying the graphene by adding a functional group selected from the group consisting of sulfur, amines, and acids.

14. The coating method of claim 11 or claim 12, further comprising modifying the graphene by adding a functional group selected from the group consisting of C8-C20 hydrocarbons, fluorinated groups, and siloxane groups.

15. The coating method of any of claims 9 to 14, further comprising applying the graphene derivative with a method selected from the group consisting of chemical vapor deposition, screen printing, electrophoresis, thermal spray coating, spraying, painting, and dipping.
